# EUROPEAN PATENT APPLICATION

(11) **EP 4 432 800 A2**
(43) Date of publication of application: **18.09.2024**
(21) Application number: 24162495.6
(22) Date of filing: 08.03.2024
(51) Int. Cl.: H05K 7/20

(54) **LIQUID COOLING MANIFOLDS, COOLING SYSTEMS, SERVICE MODULES AND METHODS OF COOLING**

(30) Priority: 14.03.2023 US 202363490126 P; 04.03.2024 US 202418594306
(71) Applicant: Schneider Electric IT Corporation, Foxboro, MA 02035 (US)
(72) Inventor: ANDERSEN, Claus Aabjerg, ANDOVER, 01810 (US)
(74) Representative: Plasseraud IP

(57) **Abstract**

A liquid cooling manifold includes a manifold body having an inlet flow channel, an outlet flow channel and an expansion channel. The liquid cooling manifold further includes a plurality of distribution inlet connectors coupled to the manifold body and in fluid communication with the inlet flow channel. The liquid cooling manifold further includes a plurality of distribution outlet connectors coupled to the manifold body and in fluid communication with the outlet flow channel. The liquid cooling manifold further includes a heat exchanger coupled to the manifold body.

## Description

### BACKGROUND OF DISCLOSURE

Cooling systems to cool electronic equipment, such as power modules, within an equipment rack are known in the art. Such cooling systems include using a heat transfer fluid, sometimes referred to liquid cooling, to remove heat from the electronic equipment provided in an equipment rack. Specifically, liquid cooled equipment accepts cool liquid that conducts heat away from the electronic components of the equipment. One type of cooling system includes a manifold configured to carry the liquid to and from multiple pieces of equipment. Such a cooling system needs additional components to operate, including, but not limited to, an expansion tank, a heat exchanger, and an air trap. The connections between these additional components and the manifold introduce failure points in which leakage can occur thereby potentially damaging the electronic equipment cooled by the system. Further, the equipment may be coupled to the manifold with hoses, which can also fail. Servicing these components may require removing or adding fluid to the system, which increases the complexity of the service.

### BRIEF DESCRIPTION OF DRAWINGS

The accompanying drawings are not intended to be drawn to scale. In the drawings, each identical or nearly identical component that is illustrated with various figures, is represented by a line numeral. For purposes of clarity, not every component may be labeled in every drawing. In the drawings:
FIG. 1 is a perspective view of a portion of a panel board including an equipment rack having several power modules;
FIG. 2 is a perspective view of an example power module, including a 3-phase inverter power module, with outer packaging removed to reveal components of the power module;
FIG. 3 is a side view of the power module shown in FIG. 2;
FIG. 4 is a schematic view of an example cooling system of the present disclosure;
FIG. 5 is a perspective view of a cooling system including three manifolds of an embodiment of the present disclosure;
FIG. 6 is a perspective view of an example manifold of the cooling system;
FIG. 7 is a perspective view of an example manifold with the manifold sectioned to reveal flow channels and an expansion channel of the manifold;
FIG. 8 is a perspective view of an example manifold shown, an end of the manifold having an opening to the expansion channel;
FIG. 9 is a perspective view of an example cold plate of an example cooling system;
FIG. 10 is an enlarged perspective view of an example cold plate showing an inlet connector, and outlet connector and a pump of the cold plate;
FIG. 11 is an enlarged perspective view of the cold plate shown in FIG. 8 having stops on the inlet connector and the outlet connector.
FIG. 12 is a perspective view of a portion of an example manifold and of an example cold plate showing an alignment pin of the cold plate provided to enhance the alignment of the inlet connector and the outlet connector of the cold plate to mating connectors of the manifold;
FIG. 13 is a perspective view of a cold plate of an embodiment of the disclosure;
FIG. 14 is an exploded perspective view of the cold plate shown in FIG. 13;
FIG. 15 is a perspective view of a service module of an embodiment of the present disclosure;
FIG. 16 is a perspective view of a manifold of another embodiment of the present disclosure;
FIG. 17 is an exploded perspective view of the manifold shown in FIG. 16;
FIG. 18 is a perspective view of a manifold of yet another embodiment of the present disclosure;
FIG. 19 is an exploded perspective view of the manifold shown in FIG. 18;
FIG. 20 is a perspective view of a manifold of another embodiment of the present disclosure; and
FIG. 21 is an exploded perspective view of the manifold shown in FIG. 20.

### DETAILED DESCRIPTION

A cooling system of embodiments of the present disclosure include a manifold and other components, which are arranged as a modular system with minimal or reduced risk of leak and introduction of air bubbles or dirt during operation and service. With blind mate interface connectors, each power module of the UPS can be removed from the system without or with reduced loss or leak of fluid from the cooling system. The system includes a pump, which can be controlled in speed to deliver a minimum or reduced flow and thereby deliver the maximum or an increased delta in cooling temperature. Weak points in such cooling systems are gaskets and hoses, each having a history of failure due to aging and lack of maintenance. The manifold of embodiments of the present disclosure includes integrally formed inlet and outlet flow channels, an expansion chamber and a heat exchanger. Embodiments of the manifold further include inlet and outlet connectors that are welded or brazed to the manifold. The manifold is configured to have maximum or increased functionality without hoses and minimum or reduced usage of gaskets.

An extruded manifold includes an integrated expansion channel having hollow objects, e.g., rubber bladders, to provided expansion, a welded or brazed heat exchanger, a tongued surface for fixation to a frame and easy removal of the manifold, a flat surface for precise milling of threaded openings, and a complete unit or system that is configured for shipping with cooling fluid provided in the manifold.

Embodiments of the present disclosure are directed to a manifold of a cooling system configured to cool electronic components, e.g., a power module, of a UPS. The electronic equipment the uninterruptible power supply (UPS) cooled by the system is coupled to the manifold without hoses, thereby reducing opportunities for leakage. As mentioned, the equipment can be shipped with fluid, thereby decreasing the complexity required to service the system.

Further, embodiments of the present disclosure are directed to a service module configured to include a tank for temporary storage of liquid during repair or freshening of the cooling system defined by the manifold, a tank with new liquid for the cooling system, a particle filter to purify old liquid, an ultrasonic vibrator to deplete the liquid of air from the cooling system, a vacuum pump to draw air out of the cooling system before filling the cooling system with liquid, a pH sensor to verify pH of the fluid in the cooling system, and a pump to re-pressurize the cooling system after service.

This disclosure is not limited in its application to the details of construction and the arrangement of components set forth in the following descriptions or illustrated by the drawings. The disclosure is capable of other embodiments and of being practiced or of being carried out in various ways. Also, the phraseology and terminology used herein is for description purposes and should not be regarded as limiting. The use of "including," "comprising," "having," "containing," "involving," and variations herein, are meant to be open-ended, i.e., "including but not limited to."

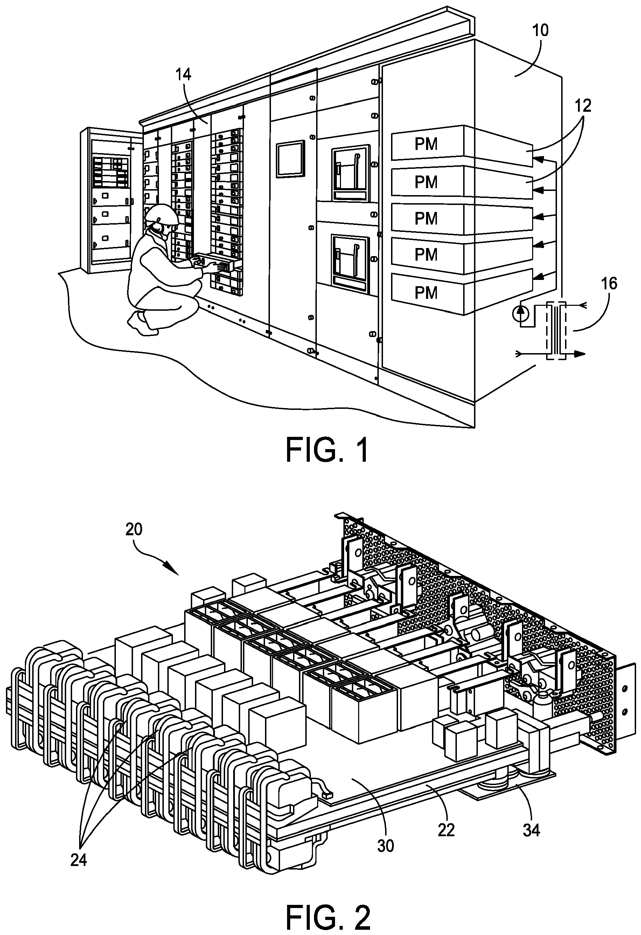

Referring to the drawings, and more particularly to FIG. 1, a portion of a panel board is shown. The panel board includes equipment racks, including equipment rack 10, which is configured to support several power modules, each indicated 12. The panel board further includes switchgear indicated at 14. As is known, the power modules generate heat, which in closed spaces, if not properly addressed can cause the electronic equipment to fail. Cooling systems are provided to address heat build-up with the equipment rack. One such system embodies a liquid cooling system configured to deliver cooled fluid (water or refrigerant) to a cold plate associated with the power module. Since several power modules 12 are included within the equipment rack 10, the system may be able to deliver cooled fluid to each plate. A heat exchanger 16 is provided as part of the cooling system to cool fluid heated by the power modules. In embodiments of the present disclosure, the heat exchanger 16 is provided as part of a manifold used to distribute fluid to the power modules 12.

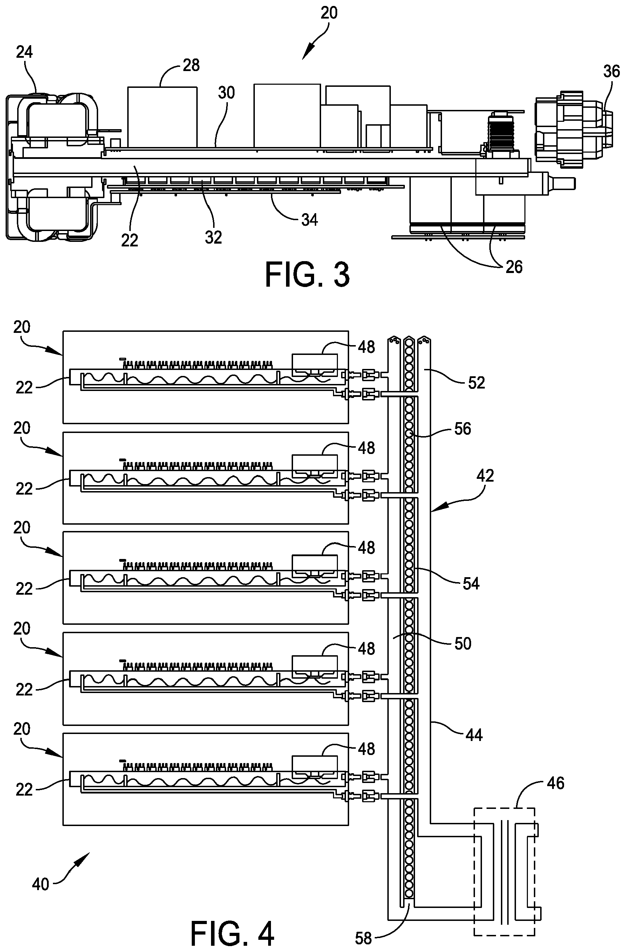

Referring to FIGS. 2 and 3, an example power module generally indicated at 20 having a cold plate 22 is shown. The power module 20 includes chokes, each indicated at 24, and DC capacitors, each indicated at 26, mounted directly to the cold plate. The power module 20 further includes electronic components 28 mounted on an electronic substrate 30 above the cold plate 22. Such electronic components 28 include fuses, relays EMC caps, and the like. The power module 20 further includes transistors 32 mounted on another electronic substrate 34 below the cold plate 22. In one embodiment, the cold plate 22 includes a relatively warmer end near the chokes 24 and a relatively cooler end near the capacitors 26. The arrangement is such that the capacitors 26 and the transistors 32 may require cooling. The components of the power module 20 including the capacitors 26 and the transistors 32 are configured to be thermally coupled to the cold plate 22 to draw heat from and otherwise cool the components.

The power module 20 further includes a blind mate connector 36 to provide electrical communication from the equipment rack to the power module. As will be discussed in greater detail below, the power module 20 further includes two liquid cooling connectors, which will be described in great detail below, to provide cooled fluid to and remove heated fluid from the cold plate 22.

Referring to FIG. 4, a cooling system of an embodiment of the present disclosure is generally indicated at 40. As shown, the cooling system 40 includes a manifold, generally indicated at 42, which is configured to deliver cooled fluid to and return heated fluid from the cold plates 22 of the power modules 20. The manifold 42 is configured to connect to the cold plates 22 of the power modules 20 without the need of hoses and gaskets to prevent or reduce leakage of the cooling system 40 during operation and maintenance. The manifold 42 includes a manifold body 44 and an integral heat exchanger 46, which is secured to the manifold body to cool heated fluid delivered through the manifold body to the heat exchanger. The arrangement is such that heated fluid from the cold plates 22 flows through the manifold body 44 to the heat exchanger 46, is cooled by the heat exchanger, and flows through the manifold body back to the cold plates. Each cold plate 22 includes a pump 48 to distribute and disperse the cooled fluid, which is heated by the components of the power module 20. The heated fluid returns to the manifold 42 from the cold plates 22 and is delivered by the manifold to the heat exchanger 46. The heat exchanger 42 is configured to cool the heated fluid where the cycle begins again.

As will be discussed in greater detail below, the manifold 42 is configured with an inlet flow channel 50 for cooled fluid, an outlet flow channel 52 for heated fluid, and an expansion channel 54 disposed between the flow channels to enable expansion of the flow channels. As shown, the expansion channel 54 includes a plurality of flexible bladders or balls, together indicated at 56, which are disposed within the expansion channel. The balls 56, which sometimes may be referred to as pressurized shapes, are configured to compress under pressure when pressurized fluid enters the expansion channel 54 from one or both of the inlet flow channel 50 and the outlet flow channel 52 and to expand when the pressurized fluid exits the expansion channel. Stated another way, the pressurized shape is configured to exert pressure on the fluid within the expansion channel 54. Although balls 56 are shown in FIG. 4, a single flexible bladder or multiple bladders may be inserted into the expansion channel 54 to perform the function of the expandable balls. In one embodiment, the flexible balls are made from rubber or a rubber-like material to achieve the pressurized shape. The inlet flow channel 50 and the outlet flow channel 52 are in fluid communication with expansion channel 54 by a coupling indicated at 58 in FIG. 4. The coupling 58 enables pressurized fluid to enter the expansion channel 54 where the pressurized fluid is allowed to expand and compress the balls 56.

The manifold 42 further is configured to contain cooling fluid, e.g., water, glycol or a water/glycol mixture. The arrangement is such that the manifold 42 provides a "feeling of non-liquid" in that the manifold is designed for lifetime use without scheduled service, is filled with the cooling fluid at the factory and shipped with the cooling fluid. The manifold 42 is manufactured for use in a clean environment in which ultrasonic vibration can be employed to deplete air and a vacuum applied before filling to eliminate bubbles. Additives can be added to the water or water/glycol solution to prevent or reduce organic growth.

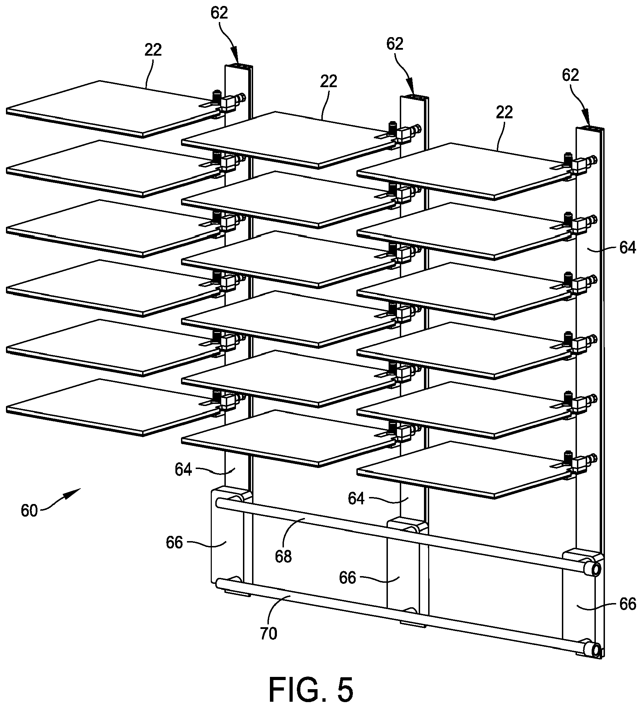

Referring to FIG. 5, in one embodiment, a cooling system, generally indicated at 60, includes three manifolds, each generally indicated at 62, which may be similar or identical to manifold 42. Each manifold 62 includes an elongated manifold body 64 each having a dedicated heat exchanger 66. The heat exchangers 66 of the manifolds 62 are connected to one another by lines 68, 70, which provide cooled fluid to and return heated fluid from the heat exchangers. In some embodiments, the lines 68, 70 are connected to an external chiller configured to cool the heated fluid delivered to the chiller by line 68 and to return cooled fluid to the heat exchangers of the manifold by line 70. Each manifold 62 is configured to provide cooling to six cold plates 22; however, the manifold can be configured to provide cooled fluid to and return heated fluid from any number of cold plates provided along a length of the manifold body 64. As described above, each manifold 62 is configured to deliver cooled fluid to the cold plates 22 and configured to exhaust heated fluid from the cold plates.

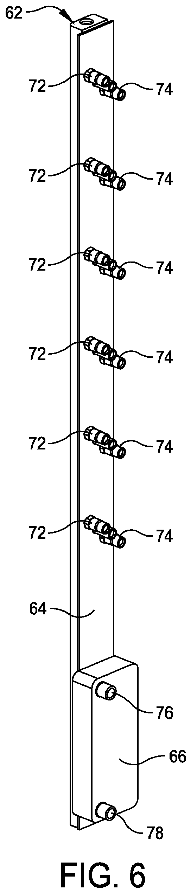

Referring to FIG. 6, the manifold 62 includes an elongated structure embodying the manifold body 64 having a plurality of inlet connectors, each indicated at 72, and outlet connectors, each indicated at 74, provided along a length of the manifold body. As shown, six sets of connectors 72, 74 are provided, with each set including an inlet connector 72 and an outlet connector 74 for a respective cold plate 22. As described above, the manifold 62 further includes the heat exchanger 66 provided at a lower end of the manifold body 64. In one embodiment, the heat exchanger 66 is welded or brazed to the manifold body 64 to create a unitary structure. The heat exchanger 66 of the manifold 62 includes an inlet connector 76 configured to connect to line 68 and an outlet connector 78 configured to connect to line 70.

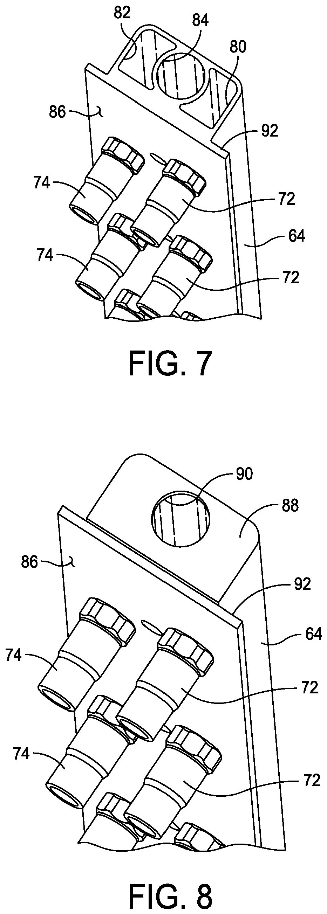

Referring to FIG. 7, the manifold body 64 of the manifold 62 includes a first inlet flow channel 80 for heated fluid to flow to the inlet connectors 72, a second outlet flow channel 82 for cooled fluid to flow to the outlet connectors 74, and an expansion channel 84 disposed between the flow channels. As with the expansion channel 54 of manifold 42, the expansion channel 84 includes a plurality of flexible bladders or balls (not shown) along the length of the expansion channel, which are provided to compress under pressure when pressurized fluid enters the expansion channel from one or both of the inlet flow channel 80 and the outlet flow channel 82. In one embodiment, the inlet flow channel 80 is configured to return heated fluid from the cold plates to heat exchanger and the outlet flow channel 82 is configured to deliver cooled fluid from the heat exchanger 66 to the cold plates. In one embodiment, the manifold body 64 including the flow channels 80, 82 can be fabricated from extruding aluminum, an aluminum alloy or some other suitable metal.

In one embodiment, the inlet flow channel 80 is in fluid communication with each inlet connector 72 to return heated fluid to the outlet flow channel. Similarly, the outlet flow channel 82 is in fluid communication with each outlet connector 74 to deliver cooled fluid to the inlet connector. The arrangement is such that the heated fluid is returned from the cold plates by the outlet connectors 74 in fluid communication with the outlet flow channel 82 and heated fluid is delivered to the cold plates 22 by the inlet connectors in fluid communication with the inlet flow channel.

In the shown embodiment, the expansion channel 84 is disposed between the inlet flow channel 80 and the outlet flow channel 82, as described above with respect to manifold 42, and can include rubber or rubber-like balls or bladders that extends a length of the manifold body 64 within the expansion channel. As discussed, one purpose of the expansion channel 84 is to provide a space for the inlet flow channel 80 and/or the outlet flow channel 82 to expand in the event the manifold 60 is subject to water expansion from temperature variations. The expansion channel 84 further is provided to store extra fluid within the system to account for lost/evaporated fluid and to maintain a higher pressure in the system than ambient. As with the expansion channel 54 of manifold 42, the inlet flow channel 80 and the outlet flow channel 82 are in fluid communication with the expansion channel 84 to enable pressurized fluid from the flow channels to enter the expansion channel.

The manifold body 64 includes a flat surface 86 including the inlet and outlet connectors 72, 74. In one embodiment, the flat surface 86 provides a precise surface on which threaded openings can be formed to receive the inlet connectors 72 and the outlet connectors 74.

Referring to FIG. 8, a top end of the manifold body 64 can include a capped end 88 with an opening 90 formed therein. Specifically, the opening 90 can be a threaded opening configured to receive a threaded plug (not shown) to close the interior of the manifold body 64 after fluid is dispensed within the manifold body. The manifold body 64 further can include a tongued or flanged surface 92, which is used to secure, e.g., with screw fasteners, the manifold body 64 of the manifold 62 to a frame or some other suitable support structure. Such screw fasteners can be accessed from the front of the manifold 62 to install or remove the manifold body 64 from the frame. The manifold body 64 of the manifold 62 further may include studs (not shown) located adjacent the heat exchanger 66 to secure the manifold to the structure to hold the manifold in place.

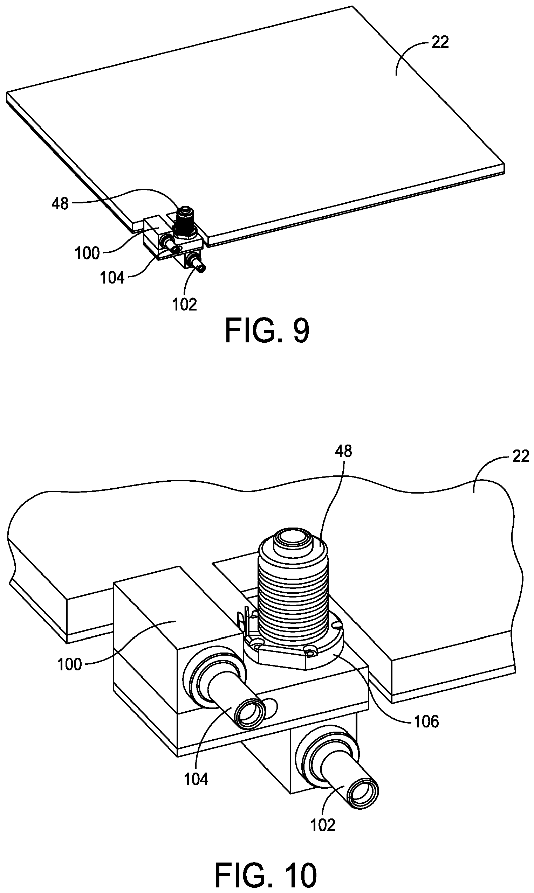

Referring to FIG. 9, the cold plate 22 is a generally rectangular, planar construction that includes a corner having a structure 100 including an inlet connector 102 and an outlet connector 104. The inlet connector 102 is configured to connect with an inlet connector 72 of the manifold body 64 of the manifold 62 and the outlet connector 104 is configured to connect with an outlet connector 74 of the manifold body of the manifold. Fluid communication between the inlet flow channel 80 is achieved through the connection of mating inlet connectors 72, 102. Similarly, fluid communication between the outlet flow channel 82 is achieved through the connection of mating outlet connectors 74, 104.

Referring to FIG. 10, the structure 100 includes the pump 48, which is in fluid communication with the inlet connector 104 to drive the cooled fluid through the cold plate 22. A redundant gasket 106 can be provided to secure the pump 48 to the structure 100.

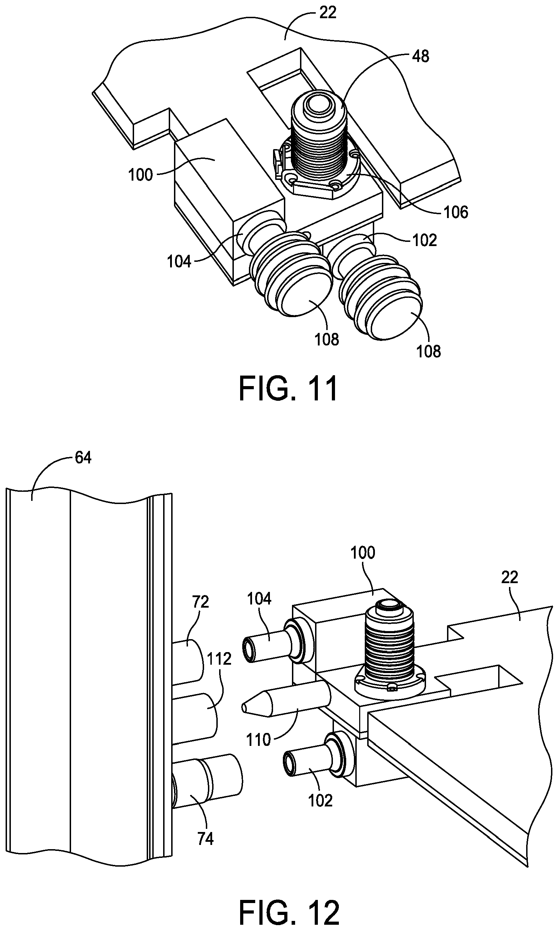

The inlet connector 102 and/or the outlet connector 104 includes a pressure relief function to prevent or reduce a risk of a burst or rapture caused by water expansion during transport. Referring to FIG. 11, a transport cap, indicated at 108, can be provided to capture spilled fluid from the cold plate 22 during transport or maintenance.

Referring to FIG. 12, in one embodiment, the cold plate 22 includes an alignment pin 110 to enhance the alignment of the inlet connector 102 and the outlet connector 104 of the cold plate with the inlet connector 72 and the outlet connector 74 of the manifold 62, respectively, when securing the cold plate to the manifold. As shown, the manifold 62 includes a receiving member 112, e.g., a cylindrical structure, configured to receive the alignment pin 110. The insertion of the alignment pin 110 into the receiving member 112 ensures the proper connection of the inlet connector 102 and the outlet connector 104 of the cold plate 22 with the respective inlet connector 72 and the outlet connector 74 of the manifold 62. The provision of the alignment pin 110 and the receiving member 112 enhances the alignment of the inlet connector 102 and the outlet connector 104. Other systems and methods can be used to align the inlet connector 102 and the outlet connector 104 of the cold plate 22 and the inlet connector 72 and the outlet connector 74 of the manifold 62.

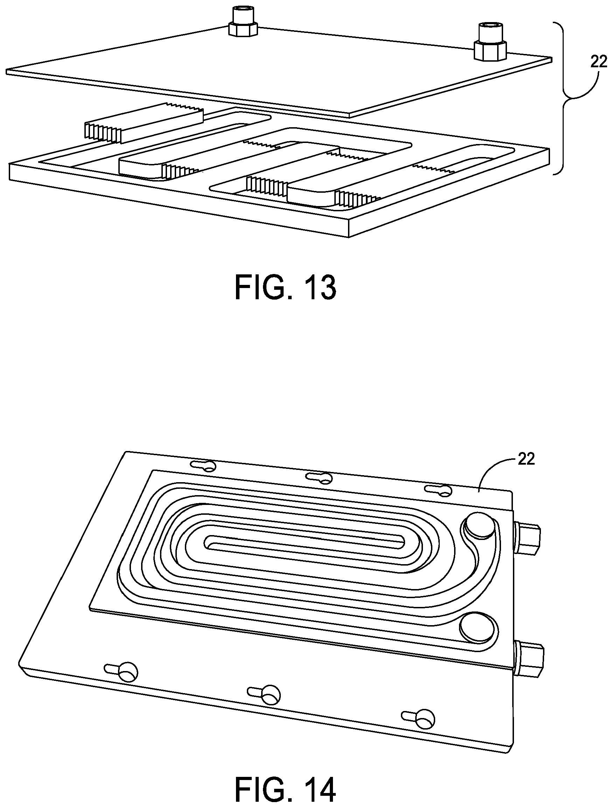

Referring to FIGS. 13 and 14, an example construction of the cold plate 22 is shown.

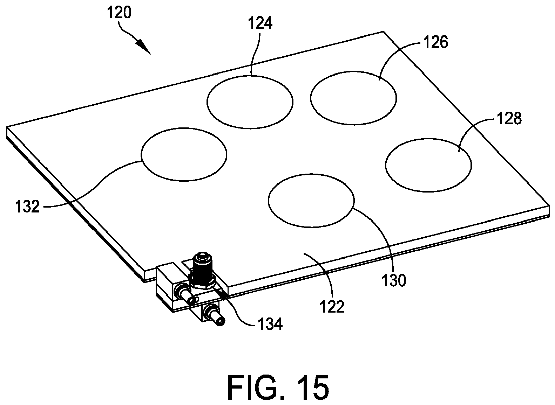

Referring to FIG. 15, a service module of an embodiment of the present disclosure is generally indicated at 120. As shown, the service module 120 includes a relatively flat, planar body 122, similar to the size and shape of the cold plate 22 and configured to provide service to the manifold 62. In one embodiment, the body 122 of the service module 120 is configured to support a tank 124 for temporary storage of liquid during repair of the cooling system defined 60 by the manifold 62, a tank 126 having new liquid for the cooling system, a particle filter 128 to purify the used liquid of the cooling system, an ultrasonic vibrator 130 to deplete the liquid of air from the cooling system, and a vacuum pump 132 to draw air out of the cooling system 60 before filling the cooling system with liquid. As shown, the body 122 of the service module 120 further includes a pump 134 to re-pressurize the cooling system after service. The service module 120 is provided for deep service of the manifold 62 in which the service module is brought on site and employed when service is required. The service module 120 can also be provided to adjust pH of the fluid.

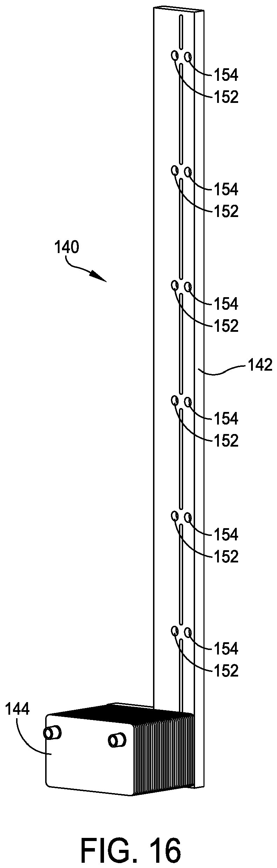

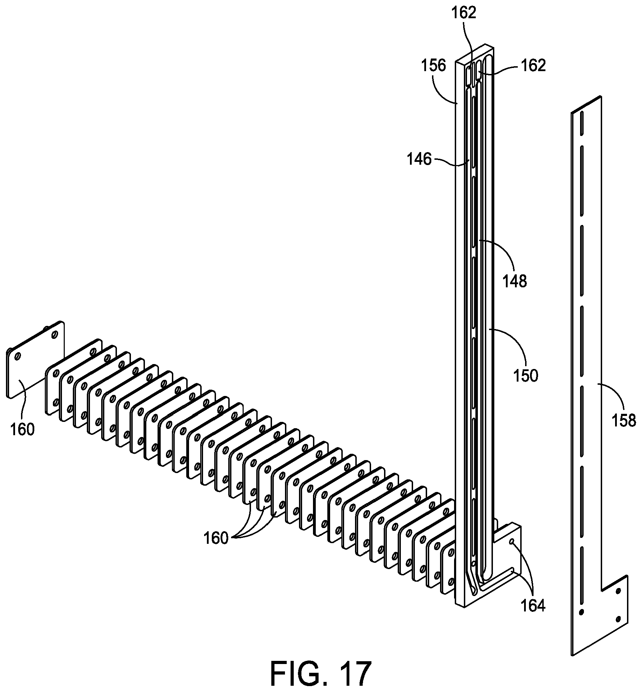

Referring to FIGS. 16 and 17, another embodiment of the manifold is generally indicated at 140. As shown, the manifold 140 is similar to manifold 42 and manifold 62, including an elongated manifold body 142, a heat exchanger 144 provided at the bottom of the manifold body, flow channels 146, 148, an expandable chamber 150, and a plurality of inlet openings each indicated at 152 and outlet openings each indicated at 154 provided along a length of the manifold body. The inlet openings 152 and the outlet openings 154 are configured to receive connectors to create inlet connectors and outlet connectors. A difference between manifold 140 and manifold 62 is the manner in which the manifold 140 is fabricated. In the shown embodiment, the manifold body 142 of manifold 140 is centered around a milled base plate 156 (material is for example aluminum). Together with a rear plate 158 and several heat exchanger plates, each indicated at 160, the entire assembly is soldered together to form a single part. The manifold 140 provides the functionality of manifold 62, including but not limited to the heat transfer function, expansion function, the ability to trap air in the fluid, and the ability to measure temperature of external cooling fluid incoming, temperature of external cooling fluid outgoing and temperature of internal cooling fluid incoming. A variety of bladder structures and materials can be used in the expandable chamber 150.

As shown, the base plate 156 is milled to create the flow channels 146, 148 and room for the expandable chamber 150. The base plate 156 further is milled to create the pockets, each indicated at 162, to trap air bubbles and pockets, each indicated at 164, to house temperature sensors provided at the bottom of the manifold body 142 to measure temperature of external cooling fluid incoming, temperature of external cooling fluid outgoing and temperature of internal cooling fluid incoming. The base plate 156 further includes several openings that can be drilled or milled to provide connection points for the manifold 140, e.g., connection points to and from the cold plates of the power modules. Elongated openings or slots can be milled or drilled between the flow channels of the base plate 156 to reduce heat transfer and to serve as an entry point for guide pins.

Further, as shown, the heat exchanger 144 of the manifold 140 includes a number of plates 160 that are stacked together to form the heat exchanger. The heat exchanger 144 of the manifold 140 includes inlet and outlet connectors to allow the cooling fluid from the external source to enter the heat exchanger and to cool the fluid contained within the manifold.

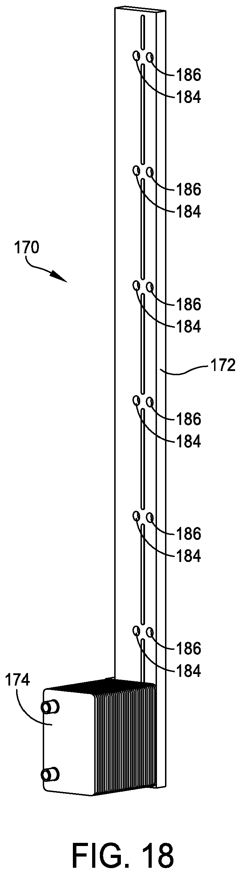

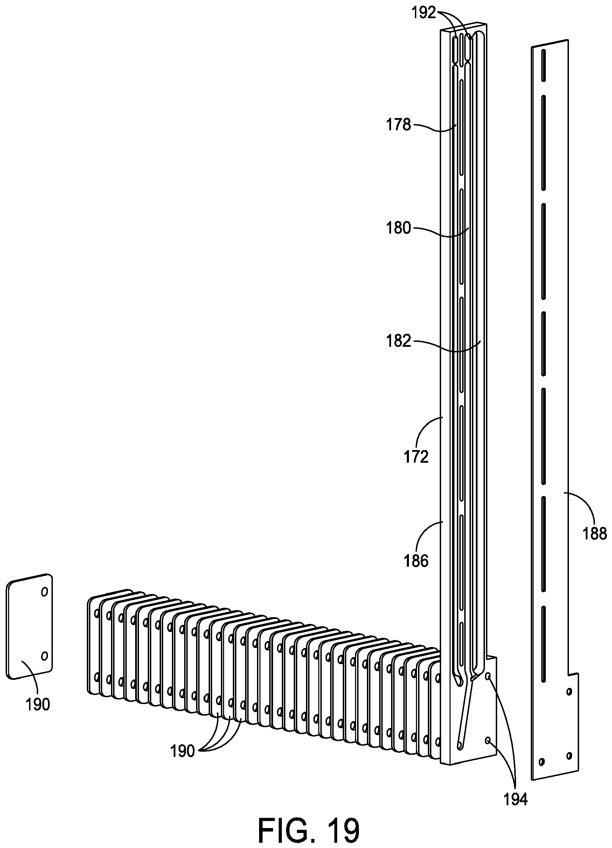

Referring to FIGS. 18 and 19, another embodiment of the manifold is generally indicated at 170. As shown, the manifold 170 is similar to manifolds 42, 62, 140, including an elongated manifold body 172, a heat exchanger 174 provided at the bottom of the manifold body, flow channels 176, 178, an expandable chamber 180, and a plurality of inlet openings, each indicated at 182, and outlet openings, each indicated at 184. A difference between manifold 170 and manifold 140 is that the heat exchanger 174 is generally in an upright orientation. One advantage associated with this design is that no air can be trapped on a customer side of the manifold 170.

As shown in FIG. 19, the manifold body 172 of manifold 170 includes a milled base plate 186 and a rear plate 188 and several heat exchanger plates, each indicated at 190, with the entire assembly being soldered together to form a single part. The base plate 186 is milled to create the flow channels 176, 178 and room for the expandable chamber 180. The base plate 186 further is milled to create the pockets, each indicated at 192, to trap air bubbles and pockets, each indicated at 194, to house temperature sensors provided at the bottom of the manifold body 142 to measure temperature of external cooling fluid incoming, temperature of external cooling fluid outgoing and temperature of internal cooling fluid incoming. The base plate 186 further includes several openings that can be drilled or milled to provide connection points for the manifold 170, e.g., connection points to and from the cold plates of the power modules. Elongated openings or slots can be milled or drilled between the flow channels of the base plate 186 to reduce heat transfer and to serve as an entry point for guide pins.

Further, as shown, the heat exchanger 174 of the manifold 170 includes a number of plates 190 that are stacked together to form the heat exchanger. The heat exchanger 174 of the manifold 170 includes inlet and outlet connectors to allow the cooling fluid from the external source to enter the heat exchanger and to cool the fluid contained within the manifold.

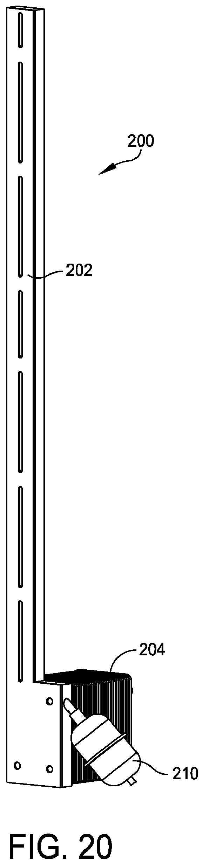

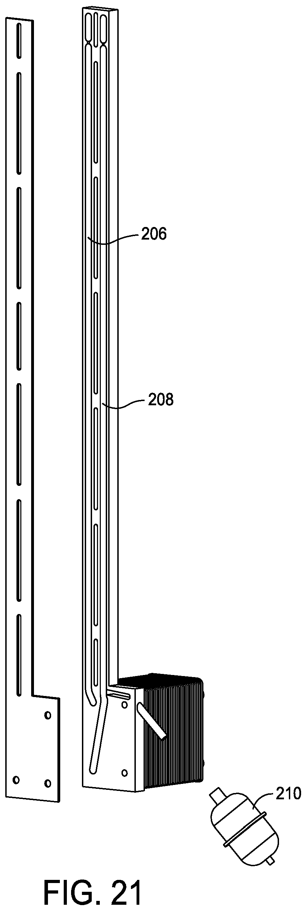

Referring to FIGS. 20 and 21, another embodiment of the manifold is generally indicated at 200. The manifold 200 is similar to manifolds 62, 140 and 170, including an elongated manifold body 202, a heat exchanger 204 provided at the bottom of the manifold body, flow channels 206, 208, and a plurality of inlet openings and outlet openings provided along a length of the manifold body. With this embodiment, the manifold 200 includes an expansion tank 210, which is a standard commercially available expansion tank provided on a side of the manifold body 202. One advantage associated with this design is that the external expansion tank is a readily commercially available product.

In some embodiments, a method of cooling a plurality of power modules includes delivering cooling fluid in a relatively cool state to power modules from a manifold in fluid communication with the power modules, returning cooling fluid in a relatively heated state from the power modules to the manifold, and cooling the cooling fluid in the relatively heated state with a heat exchanger coupled to the manifold. As discussed above, the manifold includes the manifold body having the inlet flow channel to deliver cooled fluid to the power modules, an outlet flow channel to return heated fluid from the power modules, and an expansion channel configured with a bladder to expand and contract. The expansion channel provides a space for the inlet flow channel and/or the outlet flow channel to expand in the event the manifold is subject to water expansion from temperature variations.

In some embodiments, a controller may be provided to control the cooling system. Various controllers may execute various operations discussed above with respect to the cooling system. Using data stored in associated memory and/or storage, the controller also executes one or more instructions stored on one or more non-transitory computer-readable media, which the controller may include and/or be coupled to, that may result in manipulated data. In some examples, the controller may include one or more processors or other types of controllers. In one example, the controller is or includes at least one processor. In another example, the controller performs at least a portion of the operations discussed above using an application-specific integrated circuit tailored to perform particular operations in addition to, or in lieu of, a general-purpose processor. As illustrated by these examples, examples in accordance with the present disclosure may perform the operations described herein using many specific combinations of hardware and software and the disclosure is not limited to any particular combination of hardware and software components. Examples of the disclosure may include a computer-program product configured to execute methods, processes, and/or operations discussed above. The computer-program product may be, or include, one or more controllers and/or processors configured to execute instructions to perform methods, processes, and/or operations discussed above.

In some embodiments, the inverter buildup of an example power module includes a liquid cold plate provided at a center of the inverter, a cold end for heat sensitive components, and a warm end for choke.

In some embodiments, a cooling system manifold includes components arranged in a modular system with minimal or reduced risk of leak during operation and service. The manifold includes blind mate interface connectors configured to enable each power module to be removed from the system without loss or leak.

In some embodiments, a heat exchanger is brazened to a liquid cooling manifold.

In some embodiments, an expansion channel extends a length of the manifold, within or inside the manifold.

In some embodiments, an air trap is located at a top of the manifold.

In some embodiments, distribution connectors are configured to mate directly with electronic equipment of the UPS instead of with hoses.

In some embodiments, the manifold includes an inlet channel, distribution outlet connectors and distribution inlet connectors.

In some embodiments, a manifold can be independently replaced by a new manifold.

In some embodiments, the manifold includes independent sections configured to prevent or reduce a leak propagation from one section to an adjacent section.

In some embodiments, the cooling system includes several distribution pumps to provide redundancy within the system.

In some embodiments, the manifold includes an internal cooling loop fabricated from aluminum or an aluminum alloy to mitigate the risk of galvanic corrosion.

In some embodiments, the manifold includes an external cooling side piping coated to reduce sensitivity to the choice of pipe materials.

Further examples are provided in the following clauses.

Clause 1. A liquid cooling manifold, comprising:
a manifold body including an inlet flow channel, an outlet flow channel and an expansion channel;
a plurality of distribution inlet connectors coupled to the manifold body and in fluid communication with the inlet flow channel;
a plurality of distribution outlet connectors coupled to the manifold body and in fluid communication with the outlet flow channel; and
a heat exchanger coupled to the manifold body.

Clause 2. The liquid cooling manifold of clause 1, wherein the expansion channel includes at least one pressurized shape disposed within the expansion channel, the at least one pressurized shape being configured to expand and contract.

Clause 3. The liquid cooling manifold of clause 1, wherein the manifold body is an elongated structure having the heat exchanger provided at an end of the manifold body.

Clause 4. The liquid cooling manifold of clause 1, wherein an inlet connector of the plurality of inlet connectors and an outlet connector of the plurality of outlet connectors are configured to be secured to mating connectors of a cold plate.

Clause 5. The liquid cooling manifold of clause 4, wherein the cold plate is configured to support components of a power module.

Clause 6. The liquid cooling manifold of clause 4, wherein the cold plate includes a pump to distribute and disperse cooling fluid within the cold plate.

Clause 7. The liquid cooling manifold of clause 4, wherein the cold plate is a generally rectangular, planar structure that includes a corner having a structure including the inlet connector and the outlet connector.

Clause 8. The liquid cooling manifold of clause 7, wherein the manifold includes a receiving member configured to mate with an alignment pin of a cold plate.

Clause 9. The liquid cooling manifold of clause 1, wherein the inlet flow channel is configured to receive cooled fluid and the outlet flow channel is configured to receive heated fluid.

Clause 10. The liquid cooling manifold of clause 1, wherein the expansion channel is disposed between the inlet flow channel and the outlet flow channel.

Clause 11. The liquid cooling manifold of clause 1, wherein the inlet flow channel and the outlet flow channel of the manifold are configured to seal a fluid including at least one of water, glycol or a water/glycol mixture.

Clause 12. A cooling system comprising three manifolds, each manifold including the liquid cooling manifold of clause 1.

Clause 13. The cooling system of clause 12, wherein the heat exchanger of each manifold is connected to lines to provide cooled fluid to and return heated fluid from the heat exchanger.

Clause 14. The cooling system of clause 13, wherein the lines are connected to an external chiller configured to cool the heated fluid delivered to the chiller by a first line and to return cooled fluid to the heat exchangers of the manifold by a second line.

Clause 15. The cooling system of clause 12, wherein the cooling system is configured to cool an uninterruptable power supply.

Clause 16. A service module for a manifold of a cooling system, the service module comprising:
a body;
a tank coupled to the body to temporarily store liquid during repair of the cooling system; and
a pump coupled to the body to re-pressurize the cooling system after service.

Clause 17. The service module of clause 16, wherein the service module includes a tank coupled to the body to store new liquid for the cooling system.

Clause 18. The service module of clause 16, further comprising a particle filter coupled to the body to purify used liquid of the cooling system.

Clause 19. The service module of clause 16, further comprising an ultrasonic vibrator coupled to the body to deplete the liquid of air from the cooling system.

Clause 20. The service module of clause 16, further comprising a vacuum pump coupled to the body to draw air out of the cooling system before filling the cooling system with liquid.

Clause 21. The service module of clause 16, further comprising a sensor supported by the body to monitor and/or control a pH of fluid of the cooling system.

Clause 22. A method of cooling a plurality of power modules, the method comprising:
delivering cooling fluid in a relatively cool state to power modules from a manifold in fluid communication with the power modules;
returning cooling fluid in a relatively heated state from the power modules to the manifold; and
cooling the cooling fluid in the relatively heated state with a heat exchanger coupled to the manifold,
wherein the manifold including a manifold body having an inlet flow channel, an outlet flow channel and an expansion channel, the expansion channel including at least one pressurized shape disposed within the expansion channel, the at least one pressurized shape being configured to expand and contract, the expansion channel being in fluid communication with at least one of the inlet flow channel and the outlet flow channel and providing a space for the inlet flow channel and/or the outlet flow channel to expand in the event the manifold is subject to water expansion from temperature variations.

Clause 23. The method of clause 22, wherein the manifold includes a manifold body having a plurality of distribution inlet connectors in fluid communication with the inlet flow channel and a plurality of distribution outlet connectors in fluid communication with the outlet flow channel.

Clause 24. The method of clause 23, wherein an inlet connector of the plurality of inlet connectors and an outlet connector of the plurality of outlet connectors are configured to be secured to mating connectors of a cold plate.

Clause 25. The method of clause 24, wherein the cold plate is configured to support components of a power module.

Clause 26. The method of clause 24, further comprising pumping and distributing cooling fluid within the cold plate.

Clause 27. The method of clause 24, further comprising aligning an inlet connector of the plurality of inlet connectors and an outlet connector of the plurality of outlet connectors when mating respective connectors of the manifold.

Clause 28. The method of clause 22, wherein the heat exchanger is connected to lines to provide the relatively cooled fluid to and return the relatively heated fluid from the heat exchanger.

Clause 29. The method of clause 28, wherein the lines are connected to an external chiller configured to cool the relatively heated fluid delivered to the chiller by a first line and to return the relatively cooled fluid to the heat exchangers of the manifold by a second line.

Clause 30. The method of clause 22, wherein the expansion channel is disposed between the inlet flow channel and the outlet flow channel.

Having thus described several aspects of at least one embodiment, it is to be appreciated various alterations, modifications, and improvements will readily occur to those skilled in the art. Such alterations, modifications, and improvements are intended to be part of this disclosure and are intended to be within the scope of the disclosure. Accordingly, the foregoing description and drawings are by way of example only.

## Claims

1. A liquid cooling manifold, comprising:
a manifold body including an inlet flow channel, an outlet flow channel and an expansion channel;
a plurality of distribution inlet connectors coupled to the manifold body and in fluid communication with the inlet flow channel;
a plurality of distribution outlet connectors coupled to the manifold body and in fluid communication with the outlet flow channel; and
a heat exchanger coupled to the manifold body.

2. The liquid cooling manifold of claim 1, wherein the expansion channel includes at least one pressurized shape disposed within the expansion channel, the at least one pressurized shape being configured to expand and contract.

3. The liquid cooling manifold of claims 1 or 2, wherein the manifold body is an elongated structure having the heat exchanger provided at an end of the manifold body.

4. The liquid cooling manifold of any of the above claims, wherein an inlet connector of the plurality of inlet connectors and an outlet connector of the plurality of outlet connectors are configured to be secured to mating connectors of a cold plate.

5. The liquid cooling manifold of claim 4, wherein the cold plate is configured to support components of a power module, to includes a pump to distribute and disperse cooling fluid within the cold plate, and/or is a generally rectangular, planar structure that includes a corner having a structure including the inlet connector and the outlet connector.

6. The liquid cooling manifold of claim 5, wherein the manifold includes a receiving member configured to mate with an alignment pin of a cold plate.

7. The liquid cooling manifold of any of the above claims, wherein the inlet flow channel is configured to receive cooled fluid and the outlet flow channel is configured to receive heated fluid.

8. The liquid cooling manifold of any of the above claims, wherein the expansion channel is disposed between the inlet flow channel and the outlet flow channel.

9. The liquid cooling manifold of any of the above claims, wherein the inlet flow channel and the outlet flow channel of the manifold are configured to seal a fluid including at least one of water, glycol or a water/glycol mixture.

10. A cooling system comprising three manifolds, each manifold including the liquid cooling manifold of any of the above claims.

11. The cooling system of claim 10, wherein the heat exchanger of each manifold is connected to lines to provide cooled fluid to and return heated fluid from the heat exchanger.

12. The cooling system of claim 1 1 wherein the lines are connected to an external chiller configured to cool the heated fluid delivered to the chiller by a first line and to return cooled fluid to the heat exchangers of the manifold by a second line.

13. The cooling system of any of the claims 10 to 12, wherein the cooling system is configured to cool an uninterruptable power supply.

14. A service module for a manifold according to any of the claims 1 to 9 of a cooling system, the service module comprising:
a body;
a tank coupled to the body to temporarily store liquid during repair of the cooling system; and
a pump coupled to the body to re-pressurize the cooling system after service.

15. The service module of claim 14, wherein the service module includes one or more of:
- a tank coupled to the body to store new liquid for the cooling system;
- a particle filter coupled to the body to purify used liquid of the cooling system;
- an ultrasonic vibrator coupled to the body to deplete the liquid of air from the cooling system;
- a vacuum pump coupled to the body to draw air out of the cooling system before filling the cooling system with liquid; and
- a sensor supported by the body to monitor and/or control a pH of fluid of the cooling system.

16. A method of cooling a plurality of power modules, the method comprising:
delivering cooling fluid in a relatively cool state to power modules from a manifold in fluid communication with the power modules;
returning cooling fluid in a relatively heated state from the power modules to the manifold; and
cooling the cooling fluid in the relatively heated state with a heat exchanger coupled to the manifold,
wherein the manifold including a manifold body having an inlet flow channel, an outlet flow channel and an expansion channel, the expansion channel including at least one pressurized shape disposed within the expansion channel, the at least one pressurized shape being configured to expand and contract, the expansion channel being in fluid communication with at least one of the inlet flow channel and the outlet flow channel and providing a space for the inlet flow channel and/or the outlet flow channel to expand in the event the manifold is subject to water expansion from temperature variations.

17. The method of claim 16, further comprising pumping and distributing cooling fluid within the cold plate.

18. The method of claim 16, wherein
the manifold includes a manifold body having a plurality of distribution inlet connectors in fluid communication with the inlet flow channel and a plurality of distribution outlet connectors in fluid communication with the outlet flow channel;
an inlet connector of the plurality of inlet connectors and an outlet connector of the plurality of outlet connectors are configured to be secured to mating connectors of a cold plate,
the method further comprising aligning an inlet connector of the plurality of inlet connectors and an outlet connector of the plurality of outlet connectors when mating respective connectors of the manifold.
